# FASCICULE DE BREVET EUROPEEN

(11) **EP 0 725 768 B1**
(45) Date de publication et mention de la délivrance du brevet: **28.01.1998**
(21) Numéro de dépôt: 94926982.3
(22) Date de dépôt: 14.09.1994
(51) Int. Cl.: C04B 41/45, C23C 16/00

(54) **PROCEDE D'INFILTRATION CHIMIQUE EN PHASE VAPEUR D'UN MATERIAU AU SEIN D'UN SUBSTRAT FIBREUX AVEC ETABLISSEMENT D'UN GRADIENT DE TEMPERATURE DANS CELUI-CI**
VERFAHREN ZUR CHEMISCHEN GASPHASENINFILTRATION EINES MATERIALS IN DAS INNERE EINES FASERSUBTRATS DURCH EINEN TEMPERATURGRADIENTEN IM SUBSTRAT
CHEMICAL VAPOUR INFILTRATION PROCESS OF A MATERIAL WITHIN A FIBROUS SUBSTRATE WITH CREATION OF A TEMPERATURE GRADIENT IN THE LATTER

(30) Priorité: 27.10.1993 FR 9312805
(43) Date de publication de la demande: 14.08.1996
(73) Titulaire: SOCIETE EUROPEENNE DE PROPULSION, 92150 Suresnes (FR)
(72) Inventeur: CHRISTIN, François, F-33160 Saint-Aubin-de-Médoc (FR)
(74) Mandataire: Joly, Jean-Jacques
(86) Numéro de dépôt international: FR9401075
(87) Numéro de publication internationale: WO9511869

(56) Documents cités:
- WO-A-87/04733
- FR-A- 2 427 197
- FR-A- 2 670 507
- GB-A- 2 177 345
- GB-A- 2 177 431
- 16TH NATIONAL SAMPE SYMPOSIUM, 21 Avril 1971, ANAHEIM, US pages 257 - 265.13 W.V. KOTELENSKY 'A review of CVD carbon infiltration of porous substrates' cité dans la demande
- ACS SYMPOSIUM SERIES, vol.21, 1976, WASHINGTON US pages 212 - 227 J.J. GEBHARDT ET AL 'Formation of carbon-carbon composite materials by pyrolytic infiltration' cité dans la demande

## Description

La présente invention concerne un procédé d'infiltration chimique en phase vapeur d'un matériau au sein d'un substrat fibreux.

Le domaine d'application de l'invention est notamment celui de la fabrication de pièces en matériaux composites comprenant un substrat fibreux, ou préforme, densifié par une matrice. Dans cette application, l'infiltration chimique en phase vapeur est employée pour former un dépôt du matériau constitutif de la matrice sur les fibres du substrat, dans tout le volume de celui-ci, afin de lier les fibres entre elles et combler la porosité initiale accessible du substrat. L'infiltration chimique en phase vapeur peut également être utilisée pour compléter une densification partielle réalisée par un autre procédé par exemple par voie liquide, celle-ci consistant à imprégner le substrat par un précurseur liquide du matériau constitutif de la matrice, puis à transformer le précurseur, généralement par traitement thermique.

Pour réaliser l'infiltration chimique en phase vapeur, le substrat fibreux est placé dans une enceinte. Une phase gazeuse réactionnelle est admise dans l'enceinte. Dans des conditions de température et de pression déterminées, la phase gazeuse diffuse au sein du substrat et forme le dépôt du matériau de la matrice par décomposition ou réaction entre ses constituants au contact des fibres.

La composition de la phase gazeuse est choisie en fonction de la nature de la matrice à réaliser. Les processus d'infiltration chimique en phase vapeur, permettant de former des matrices en carbone pyrolytique, ou pyrocarbone, ou en céramique, par exemple carbure de silicium, nitrure de bore ou oxydes réfractaires, sont bien connus.

Il existe plusieurs types de procédés d'infiltration chimique en phase vapeur: le procédé isotherme-isobare, le procédé à gradient de pression et le procédé à gradient de température.

Dans le procédé isotherme-isobare, le substrat à densifier est placé dans une enceinte isotherme. Le chauffage est assuré par exemple par un suscepteur, ou induit, en graphite qui entoure l'enceinte et est lui-même entouré par un bobinage inducteur. L'apport énergétique au substrat s'effectue essentiellement par rayonnement de l'enceinte sur le substrat. La température à l'intérieur de l'enceinte est régulée à la valeur voulue par commande du courant dans l'inducteur, tandis que la pression est réglée par liaison de l'enceinte avec une source de vide et commande du débit de la phase gazeuse admise dans l'enceinte. Le dépôt du matériau de la matrice s'effectue à l'intérieur du substrat et à la surface de celui-ci. La température et la pression sont choisies à des valeurs seulement légèrement supérieures à celles requises pour la formation du dépôt, afin d'éviter un dépôt massif en surface du substrat, dès le contact avec la phase gazeuse, qui conduirait à l'obturation rapide de la porosité de surface empêchant la densification au sein du substrat.

Toutefois, la fermeture progressive de la porosité de surface est inévitable et bloque le processus de densification avant que celle-ci soit complète au coeur du substrat. Il est alors nécessaire de procéder à un écroûtage de la surface par usinage afin de ré-ouvrir le réseau de porosités et poursuivre la densification. Plusieurs opérations intermédiaires d'écroûtage peuvent être nécessaires sur une même pièce avant d'arriver au niveau de densification souhaité.

Ce procédé, par le contrôle précis des conditions d'infiltration, permet d'obtenir une matrice de la qualité souhaitée, et ce de façon reproductible. Il présente aussi l'avantage important de permettre la densification simultanée de plusieurs pièces de formes diverses dans la même enceinte.

Face à ces avantages, qui justifient son utilisation à l'échelle industrielle, le procédé isotherme-isobare présente les inconvénients d'une durée élevée et d'un coût important, notamment pour la fabrication de pièces composites de forte épaisseur. En effet, la densification requiert des vitesses de dépôt faibles, donc des cycles de durée importante. De plus, les opérations intermédiaires d'usinage pour l'écroûtage provoquent des pertes de matière, qui contribuent à accroître le prix de revient, et l'alternance entre infiltration et écroûtage rallonge la durée totale de fabrication et son coût. Enfin, en particulier pour les pièces de forte épaisseur, un gradient de densification important subsiste inévitablement au sein d'une même pièce, le degré de densification étant sensiblement moins important au coeur de la pièce qu'à sa surface.

Le procédé à gradient de pression utilise un flux forcé de la phase gazeuse à travers la préforme. Cet écoulement forcé se traduit par une différence de pression à travers la pièce.

Outre qu'il nécessite une adaptation particulière du système de transport de la phase gazeuse, le procédé à gradient de pression présente une même limitation que le procédé isotherme-isobare. En effet, la perméabilité des pores à la phase gazeuse décroît rapidement avec formation d'un dépôt plus important du côté de la face d'entrée de la phase gazeuse. Un écroûtage périodique de cette face est nécessaire pour poursuivre la densification.

De plus, ce procédé n'est applicable que pour des configurations de substrat particulièrement simples et limitées et chaque pièce nécessite un dispositif particulier d'alimentation et de circulation de la phase gazeuse.

Le procédé à gradient de température consiste à réaliser un chauffage non uniforme du substrat, de sorte que celui-ci présente, au voisinage de sa surface exposée, une température moins élevée que dans des parties internes éloignées de cette surface. La réaction de dépôt étant thermiquement activée, la vitesse de dépôt, ou croissance de la matrice, augmente avec la température. Il s'ensuit une densification plus importante dans les parties les plus chaudes, au sein du substrat, que dans les parties les moins chaudes, au niveau de la surface exposée du substrat. On évite ainsi la formation d'un dépôt plus important en surface, avec obturation prématurée de la porosité, et la nécessité d'opérations intermédiaires. C'est à ce type de procédé d'infiltration que se rapporte la présente invention.

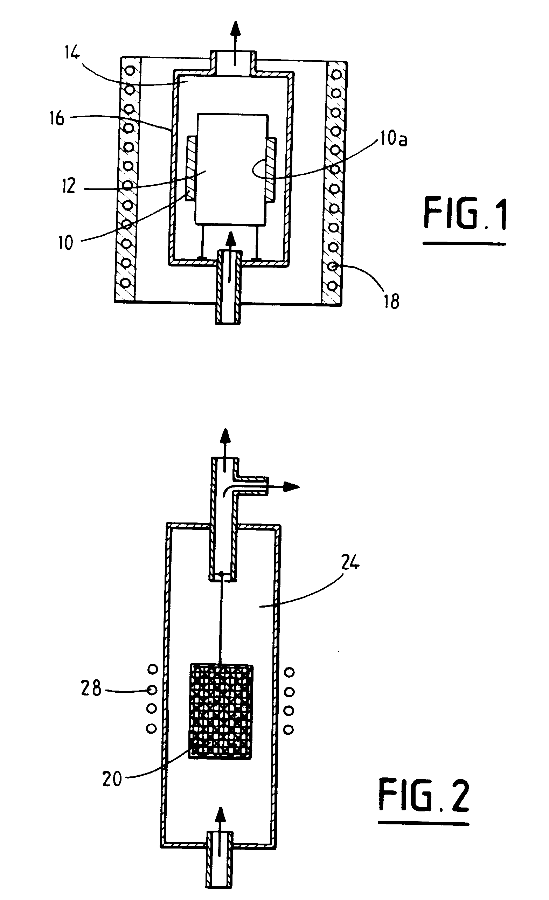

Un dispositif d'infiltration chimique en phase vapeur avec gradient de température a été présenté et décrit par W. V. Kotlensky au "16th National SAMPE Symposium, Anaheim, California, April 21-23, 1971" sous le titre "A. Review of CVD Carbon Infiltration of Porous Substrates" et dans un ouvrage intitulé "Chemistry and Physic of Carbon", édité aux Etats-Unis d'Amérique par P. L. Walker, vol. 9, p. 198-199. Ce dispositif est illustré très schématiquement par la figure 1.

Le substrat à densifier 10 est appliqué par une face interne 10a contre un induit en graphite 12. Le substrat 10 et l'induit 12 sont logés à l'intérieur d'une enceinte 14 délimitée par un tube de quartz 16. Une bobine inductrice refroidie à l'eau 18 entoure le tube 16. La phase gazeuse est admise à la base du tube 16 et circule de bas en haut.

L'induit 12 est chauffé par couplage électromagnétique avec l'inducteur 18, et chauffe à son tour le substrat 10 avec lequel il est en contact. Le substrat 10 est un feutre de fibres en carbone qui du fait de sa faible densité et du faible couplage électromagnétique avec l'inducteur n'est pas chauffé directement par induction. De plus sa faible conductivité thermique fait que, dans cette configuration, des gradients de température de plusieurs centaines de °C sont observés.

Cette technique présente plusieurs inconvénients. En particulier, seuls des substrats de relativement faible épaisseur peuvent ainsi être densifiés de façon satisfaisante. En outre, l'efficacité du chauffage de la préforme est fortement dépendante de la qualité du contact avec l'induit.

Ceci allié à l'existence d'écarts de température de plusieurs centaines de °C permet difficilement de maîtriser les conditions de dépôt de façon suffisamment précise pour garantir la formation d'une matrice ayant les caractéristiques exactes souhaitées.

Une autre technique d'infiltration chimique en phase vapeur avec gradient de température a été décrite par J. J. Gebhardt et al. dans un article intitulé "Formation of carbon-carbon composite materials by pyrolytic infiltration", Petroleum derived carbons ACS Series N° 21 6/73.

Dans ce cas (figure 2), le substrat à densifier 20 est constitué par des faisceaux de fibres de graphite entrelacés orientés dans 7 directions différentes. Le substrat est suspendu à l'intérieur d'une enceinte 24 à la base de laquelle la phase gazeuse est admise. Les fibres de graphite sont suffisamment conductrices de l'électricité pour permettre le chauffage du substrat par couplage direct avec une bobine inductrice 18 qui entoure l'enceinte.

La zone la plus chaude du substrat est située à l'intérieur de celui-ci, la surface extérieure étant refroidie par radiation et par la circulation de la phase gazeuse de bas en haut dans l'enceinte. Un gradient de température de quelques °C par centimètre est obtenu à partir de la partie interne la plus chaude.

Afin de maintenir un gradient de température suffisant, la phase gazeuse circule à vitesse élevée pour refroidir la surface et la bobine inductrice 28 est limitée à quelques spires pour chauffer une zone limitée du substrat, de sorte qu'un gradient thermique s'établit aussi entre la partie du substrat située dans le champ de l'inducteur et la partie du substrat située hors du champ. La densification de tout le substrat est obtenue en le déplaçant dans l'enceinte, parallèlement à l'axe de la bobine. Ces contraintes font que le procédé ne peut être que d'un usage limité, difficilement industrialisable.

Ainsi, la présente invention a pour but de fournir un procédé d'infiltration chimique en phase vapeur avec chauffage du substrat par couplage électromagnétique qui ne présente pas les inconvénients des procédés évoqués plus haut, en particulier un procédé utilisable à l'échelle industrielle pour des substrats pouvant avoir une grande épaisseur.

Ce but est atteint grâce à un procédé du type à chauffage du substrat par induction directe, procédé selon lequel, conformément à l'invention,
- le substrat est constitué par une texture fibreuse dans laquelle le rapport ρᵣ/ρ_{c} entre la résistivité électrique transversale et la résistivité électrique longitudinale est au moins égal à 1,3 et le rapport λᵣ/λ_{c} entre la conductivité thermique transversale et la conductivité thermique longitudinale est au plus égal à 0,9, et
- le substrat est situé entièrement dans le champ produit par l'inducteur, le substrat et l'inducteur occupant des positions fixes l'une par rapport à l'autre.

Par résistivité électrique ou conductivité thermique transversale, on entend la résistivité ou conductivité mesurée perpendiculairement aux faces latérales extérieures du substrat, en particulier la résistivité ou conductivité radiale dans le cas d'un substrat cylindrique. Par résistivité électrique ou conductivité thermique longitudinale, on entend la résistivité ou conductivité mesurée parallèlement aux faces latérales extérieures du substrat, en particulier la résistivité ou conductivité circonférentielle dans le cas d'un substrat cylindrique.

Il a été établi par la déposante qu'un substrat présentant les caractéristiques ci-dessus quant aux rapports ρᵣ/ρ_{c} et λᵣ/λ_{c} est particulièrement apte à être densifié avec chauffage par couplage électromagnétique direct. En effet, la résistivité électrique et la conductivité thermique sont telles qu'un chauffage suffisant est produit par le couplage direct, tout en créant un gradient thermique d'amplitude assez forte pour se passer de l'artifice du couplage incomplet décrit par Gebhardt et al.

Un type de substrat convenant particulièrement pour la mise en oeuvre du procédé selon l'invention et répondant aux conditions ci-dessus est constitué par une structure fibreuse aiguilletée ayant un taux volumique de fibres d'au moins 20 %.

De préférence, le taux volumique de fibres dans le substrat, c'est-à-dire le pourcentage du volume apparent du substrat effectivement occupé par les fibres, est au moins égal à 25 %.

L'utilisation de textures fibreuses aiguilletées pour constituer des textures de renfort pour des pièces en matériau composite est bien connue. Un procédé pour la réalisation de textures aiguilletées en fibres réfractaires, notamment en fibres de carbone est décrit dans les demandes de brevet FR-A-2584106 et FR-A-2 584 107. Ces textures sont constituées de strates bidimensionnelles superposées, par exemple des couches de tissu ou de nappes de fils empilées à plat ou des spires de tissu bobiné sur un mandrin. Les strates sont liées entre elles par aiguilletage. L'aiguilletage est réalisé avantageusement avec une densité constante, au fur et à mesure de la constitution de la texture.

De telles textures aiguilletées sont particulièrement aptes à la réalisation de pièces en matériau composite. En effet, la liaison des strates par aiguilletage permet de résister au délaminage, c'est-à-dire à la destruction ou l'endommagement par séparation entre strates ou glissement des strates les unes par rapport aux autres. De plus, l'aiguilletage confère à la texture fibreuse une porosité de dimension et répartition relativement uniformes dans tout le volume, favorisant la densification.

L'association entre substrat formé de texture fibreuse aiguilletée et chauffage par couplage direct peut trouver de nombreuses applications à l'échelle industrielle alors que l'art antérieur évoqué plus haut concernant le chauffage par couplage électromagnétique relève plutôt du domaine expérimental.

D'autres particularités du procédé selon l'invention ressortiront à la lecture de la description donnée ci-après à titre indicatif et non limitatif.

Sur les dessins annexés :
les figures 1 et 2, déjà décrites, montrent de façon très schématique des installations d'infiltration chimique en phase vapeur de l'art antérieur dans lesquelles le substrat à densifier est chauffé par couplage électromagnétique ;
la figure 3 montre de façon très schématique une installation permettant la mise en oeuvre d'un procédé conforme à l'invention ; et
la figure 4 illustre le gradient de température et le gradient de densité dans une pièce cylindrique densifiée par un procédé conforme à l'invention.

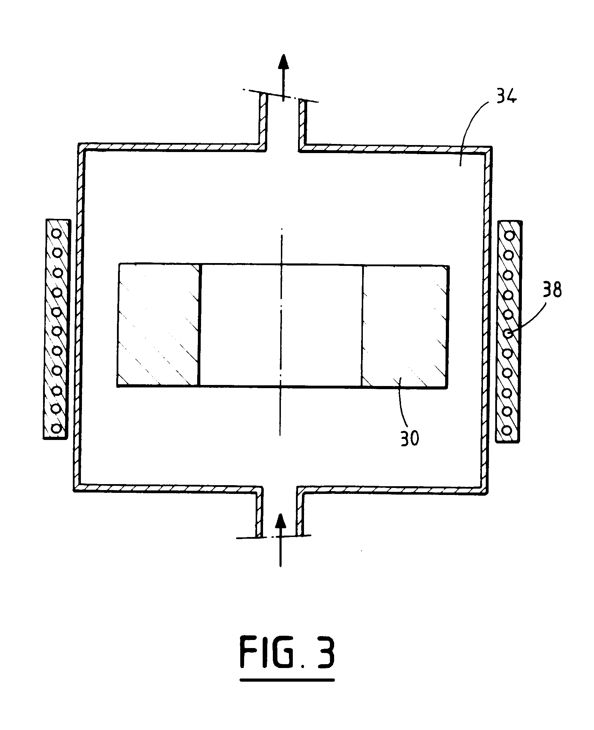

Dans l'installation de la figure 3, un substrat à densifier 30 est disposé à l'intérieur d'une enceinte 34. Le substrat a, dans l'exemple illustré, une forme cylindrique annulaire à section méridienne rectangulaire. Le chauffage du substrat est assuré par couplage électromagnétique au moyen d'un inducteur constitué par une bobine 38 qui entoure l'enceinte. Le substrat 30 et la bobine 38 sont coaxiaux. La bobine 38 s'étend axialement sur une longueur égale ou supérieure à celle du substrat 30 de sorte que celui-ci se trouve entièrement à l'intérieur du champ électromagnétique engendré par la bobine.

La densification du substrat par infiltration chimique en phase vapeur est réalisée en admettant dans l'enceinte une phase gazeuse réactionnelle dont la composition est choisie en fonction de la nature de la matrice à déposer dans le volume du substrat. La phase gazeuse est admise à la partie inférieure de l'enceinte. La fraction de la phase gazeuse n'ayant pas réagi ainsi que les produits de réaction gazeux éventuels sont extraits à la partie supérieure de l'enceinte reliée à une source de vide (non représentée).

Une installation d'infiltration chimique en phase vapeur de ce type est décrite dans la demande de brevet EP-A-0 256 073. L'installation de la figure 3 destinée à la mise en oeuvre du procédé conforme à l'invention se distingue de cette installation connue par le fait que le chauffage du substrat est assuré par couplage électromagnétique direct entre l'inducteur et le substrat, et non pas, de façon indirecte, par couplage entre l'inducteur et un induit en graphite situé à la périphérie de l'enceinte et chauffant celle-ci.

Le substrat 30 est constitué de fibres conductrices de l'électricité, telles que des fibres de carbone ou de graphite.

Le substrat 30 présente des caractéristiques de résistivité électrique et de conductivité thermique qui le rendent apte à être chauffé à la température voulue par couplage direct avec l'inducteur 38 tout en présentant un gradient thermique significatif entre sa partie interne la plus chaude et ses surfaces extérieures exposées. Ces caractéristiques sont telles que le rapport entre résistivité électrique radiale ρᵣ et résistivité électrique circonférentielle ρ_{c} est au moins égal à 1,3, tandis que le rapport entre conductivité thermique radiale λᵣ et conductivité thermique circonférentielle λ_{c} est au plus égal à 0,9.

De préférence, la résistivité électrique radiale est comprise entre 1 et 20m Ω/cm tandis que la conductivité thermique radiale est comprise entre 0,1 et 20 W/m.°K.

Un type de structure convenant particulièrement pour le substrat 30 est une structure en fibres de carbone ou graphite aiguilletée. Un procédé pour la fabrication d'une telle structure cylindrique tridimensionnelle par aiguilletage est décrit dans le document FR-A-2 584 107 déjà cité. Ce procédé consiste à bobiner une texture bidimensionnelle sur un mandrin et à l'aiguilleter simultanément au bobinage. La texture bidimensionnelle est par exemple constituée par un tissu. Le bobinage et l'aiguilletage sont réalisés avec les fibres de la texture à l'état de précurseur de carbone, par exemple à l'état de polyacrylonitrile pré-oxydé. En effet, un aiguilletage réalisé directement sur les fibres de carbone aurait sur la texture un effet trop destructeur (fils cassés). La transformation du précurseur en carbone est réalisée après formation de la structure aiguilletée, par traitement thermique. Celui-ci peut être poursuivi à des températures plus élevées afin, le cas échéant, de graphitiser au moins partiellement les fibres.

Le taux volumique de fibres dans la structure aiguilletée, c'est-à-dire le pourcentage du volume apparent de la structure effectivement occupé par les fibres est fonction du taux de fibres dans la texture bidimensionnelle de base bobinée et des caractéristiques de l'aiguilletage, celui-ci ayant un effet de compactage des couches bobinées superposées.

Le taux volumique de fibres dans la structure aiguilletée doit être au moins égal à 20 %, de préférence au moins égal à 25 %, pour satisfaire les conditions relatives à la résistivité électrique et à la conductivité thermique.

Il est bien connu que le chauffage d'un corps par induction est produit par effet Joule, par les courants induits, et que ceux-ci se concentrent en surface (effet de peau). Ce phénomène de concentration en surface est d'autant plus concentré que la fréquence du courant alimentant l'inducteur est élevée.

Pour optimiser la densification du substrat par infiltration chimique en phase vapeur, l'objectif est de créer un gradient de température entre une zone du coeur du substrat et la surface de celui-ci.

En dépit de l'effet de peau, par le choix d'une fréquence convenable et en tenant compte du refroidissement en surface du substrat par radiation et convection (écoulement de la phase gazeuse), il est possible, pour un substrat ayant les caractéristiques précitées, d'obtenir un gradient de température au sein du substrat.

A l'évidence, la fréquence la mieux adaptée dépend de plusieurs paramètres : nature des fibres constituant le substrat, épaisseur de celui-ci, valeurs de résistivité électrique et conductivité thermique, ...

A titre indicatif, pour un substrat aiguilleté en fibres de carbone obtenu comme décrit ci-dessus, la fréquence optimale se trouve dans la gamme d'environ 150 Hz à environ 3000 Hz, selon le taux de fibres et l'épaisseur du substrat.

Dans l'exemple illustré par la figure 3, le substrat 30 a une forme cylindrique à section droite circulaire. Le procédé selon l'invention peut être mis en oeuvre avec des substrats ayant d'autres formes, notamment des substrats cylindriques à section non circulaire ou des substrats axi-symétriques non cylindriques, en adaptant, le cas échéant, la forme de l'inducteur.

Deux exemples de mise en oeuvre du procédé conforme à l'invention seront maintenant décrits.

### Exemple 1

Un substrat fibreux ayant une forme cylindrique annulaire de diamètre intérieur 90 mm et de diamètre extérieur 350 mm, et destiné à constituer une texture de renfort, ou préforme, d'une pièce en matériau composite est réalisé comme suit.

Une texture bidimensionnelle constituée par un tissu de fibres de polyacrylonitrile (PAN) pré-oxydé est bobinée sur un mandrin en couches superposées.

Chaque nouvelle couche est aiguilletée sur la texture sous-jacente. On utilise à cet effet une planche à aiguilles qui s'étend axialement sur une distance au moins égale à la largeur des strates, celle-ci étant égale à la hauteur (100 mm) de la préforme à réaliser. L'aiguilletage est réalisé au fur et à mesure du bobinage, chaque nouvelle couche étant aiguilletée à une profondeur constante égale à l'épaisseur de plusieurs couches aiguilletées. Lorsque l'épaisseur désirée de la préforme a été atteinte, dans cet exemple 130 mm, une ou plusieurs passes d'aiguilletage de finition sont réalisées, de façon connue en soi, pour obtenir une densité d'aiguilletage constante dans toute la préforme.

Le tissu utilisé a une masse surfacique comprise entre 100 et 600 g/m². L'aiguilletage est réalisé avec une densité permettant d'aboutir à un taux volumique de fibres égal à 28 % dans la préforme, après traitement thermique transformant le PAN pré-oxydé en carbone.

Une telle texture a une résistivité électrique radiale ρᵣ estimée à 13 m Ω/cm, une résistivité électrique circonférentielle ρ_{c} égale à 7 m Ω/cm, ce qui donne un rapport ρᵣ/ρ_{c} égal à 1,85, une conductivité thermique radiale λᵣ estimée à 0,25 W/m.°K et une conductivité thermique circonférentielle λ_{c} = 0,5 W/m.°K, ce qui donne un rapport λᵣ/λ_{c} = 0,50.

La préforme est placée dans l'enceinte 34 et le chauffage de la préforme est assuré en alimentant l'inducteur 38 en courant de fréquence égale à 1800 Hz. Il s'établit au sein de la préforme un champ de température résultant, d'une part, des sources thermiques engendrées par les courants induits dus au couplage électromagnétique, d'autre part, des pertes thermiques à la surface extérieure de la préforme. Les pertes thermiques se produisent par convection, lors du balayage par la phase gazeuse, et par rayonnement. La phase gazeuse admise dans l'enceinte est constituée par du méthane donnant, par décomposition, une matrice de pyrocarbone.

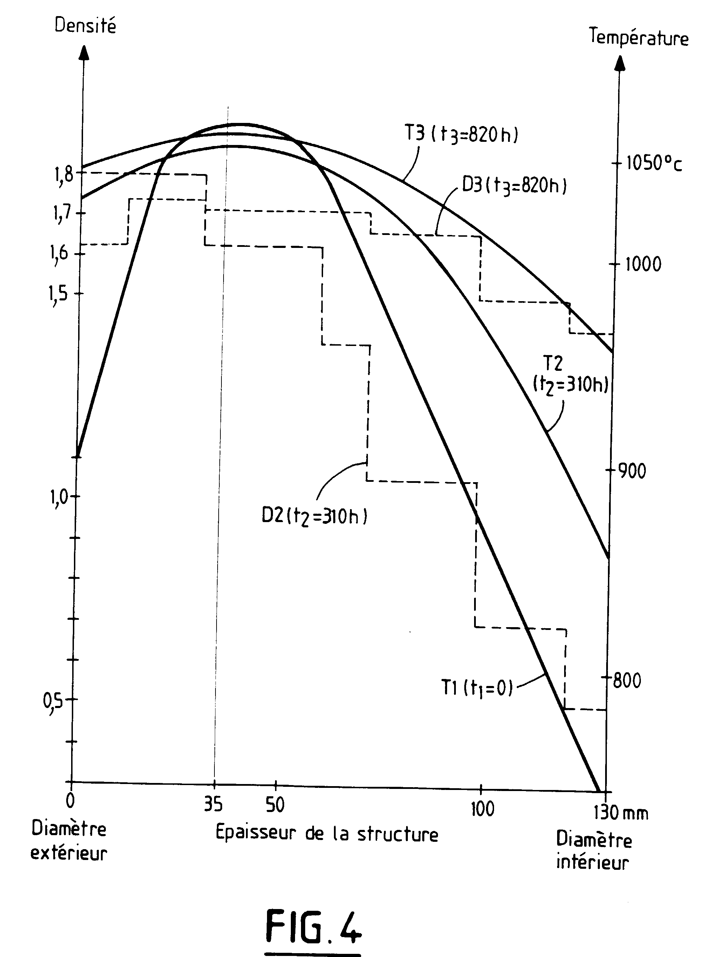

La répartition de la température dans l'épaisseur de la préforme (en direction radiale) est mesurée au début de la densification (temps t₁ = 0), après densification partielle (temps t₂ = 310 h) et en fin de densification (temps t₃ = 820 h). Les courbes T1, T2 et T3 de la figure 4 illustrent les gradients de température respectifs aux temps t₁, t₂, t₃.

La répartition de la densité dans l'épaisseur de la préforme (en direction radiale) est également mesurée aux temps t₂ et t₃. Les courbes D₂ et D₃ de la figure 4 illustrent les gradients de densité respectifs aux temps t₂ et t₃. Les mesures de densité sont effectuées en prélevant des échantillons de préforme densifiée dans sa partie médiane.

Une température maximale est atteinte dans une zone située à environ 35 mm de la surface extérieure de la préforme, et ce pendant tout le processus de densification. La densification par la matrice carbone se traduit par une variation progressive des valeurs de résistivité électrique et conductivité thermique radiales et circonférentielles. En fin de processus de densification, le rapport ρᵣ/ρ_{c} atteint la valeur 1,85 et le rapport λᵣ/λ_{c} la valeur 0,80. De façon évidente, la densification par la matrice carbone entraîne une augmentation progressive de la conductivité thermique radiale, avec, pour corollaire, une diminution du gradient thermique.

La pièce obtenue en fin de densification, au temps t₃, a une densité moyenne de 1,72, avec une valeur de densité à coeur de 1,73. Le procédé permet donc d'aboutir à une densification presque uniforme, et ce sans nécessiter d'opération d'usinage intermédiaire.

### Exemple 2

Une préforme cylindrique annulaire de diamètre extérieur 1100 mm, d'épaisseur 125 mm et de hauteur 400 mm est réalisée par bobinage et aiguilletage d'un tissu, comme dans l'exemple 1. Cette préforme est destinée à la fabrication d'un col de tuyère de propulseur.

Après carbonisation des fibres de la préforme, celle-ci est placée dans une enceinte d'une installation de densification telle que celle de la figure 3. La préforme est chauffée par couplage électromagnétique direct avec l'inducteur, ce dernier étant alimenté par un courant de fréquence égale à 150 Hz. La fréquence est inférieure à celle utilisée dans l'exemple 1, la préforme ayant un volume plus important.

La préforme est densifiée par admission dans l'enceinte d'une phase gazeuse constituée essentiellement par du méthane, donnant une matrice en pyrocarbone.

Après 920 h de densification, la densité atteinte est égale à 1,62, sans nécessiter d'usinage intermédiaire. A ce stade, les profils extérieurs du col peuvent être réalisés par usinage et la pièce est, après traitement de surface visant à la rendre étanche au gaz, prête à être utilisée.

## Revendications

1. Procédé d'infiltration chimique en phase vapeur d'un matériau au sein d'un substrat fibreux comprenant des fibres électriquement conductrices, procédé comportant les étapes qui consistent à :
- placer le substrat dans une enceinte,
- chauffer le substrat par couplage électromagnétique direct entre un inducteur et le substrat pour permettre l'établissement d'un gradient de température au sein du substrat, de sorte que celui-ci présente une température plus élevée dans des parties éloignées de ses surfaces exposées qu'au niveau de celles-ci, et
- admettre dans l'enceinte une phase gazeuse réactionnelle précurseur du matériau à infiltrer, la formation de celui-ci étant favorisée dans les parties du substrat de température plus élevée,
caractérisé en ce que
- le substrat est constitué par une texture fibreuse dans laquelle le rapport ρ ᵣ/ρ_{c} entre la résistivité électrique transversale et la résistivité électrique longitudinale est au moins égal à 1,3 et le rapport λᵣ/λ_{c} entre la conductivité thermique transversale et la conductivité thermique longitudinale est au plus égal à 0,9, et
- le substrat est situé entièrement dans le champ produit par l'inducteur, le substrat et l'inducteur occupant des positions fixes l'une par rapport à l'autre.

2. Procédé selon la revendication 1, caractérisé en ce que le substrat est constitué par une structure fibreuse aiguilletée ayant un taux volumique de fibres au moins égal à 20 %.

3. Procédé selon la revendication 2, caractérisé en ce que le taux volumique de fibres dans le substrat est au moins égal à 25%.

4. Procédé selon l'une quelconque des revendications 1 à 3, caractérisé en ce que le substrat est constitué d'une texture bidimensionnelle bobinée en couches superposées et aiguilletées.

5. Procédé selon l'une quelconque des revendications 1 à 4, caractérisé en ce que la résistivité électrique transversale de la texture fibreuse constitutive du substrat est comprise entre 1 et 20 mΩ/cm.

6. Procédé selon l'une quelconque des revendications 1 à 5, caractérisé en ce que la conductivité thermique transversale de la texture fibreuse constitutive du substrat est comprise entre 0,1 et 20 W/m.°K être réalisés par usinage et la pièce est, après traitement de surface visant à la rendre étanche au gaz, prête à être utilisée.

## Claims

1. A chemical vapour infiltration method for infiltrating a material into a fibrous substrate including electrically conductive fibers, the method comprising the following steps:
- placing the substrate in an enclosure;
- heating the substrate by direct electromagnetic coupling between the substrate and an induction winding to enable a temperature gradient to be established within the substrate such that the substrate has a temperature that is greater in its portions furthest from its exposed surfaces than in the vicinity of its exposed surfaces; and
- admitting a reaction gaseous phase into the enclosure which gaseous phase is a precursor for the material to be infiltrated, with formation of said material being enhanced in those portions of the substrate that are at higher temperature;
the method being characterised in that:
- the substrate is constituted by a fiber fabric in which the ratio ρᵣ/ρ_{c} of transversal electrical resistivity over longitudinal electrical resistivity is at least equal to 1.3, and the ratio λᵣ/λ_{c} of transversal thermal conductivity over longitudinal thermal conductivity is at the most equal to 0.9; and
- the substrate is situated entirely within the field produced by the induction winding, the substrate and the induction winding occupying positions that are stationary relative to each other.

2. The method according to claim 1, characterised in that the substrate is constituted by a needled fibrous structure having a fiber volume ratio at least equal to 20%.

3. The method according to claim 2, characterised in that the fiber volume ratio in the substrate is at least equal to 25%.

4. The method according to any one of claims 1 to 3, characterised in that the substrate is constituted by a two-dimensional fabric wound in superposed layers that are needled together.

5. The method according to any one of claims 1 to 4, characterised in that the transversal electrical resistivity of the fibrous fabric constituting the substrate lies in the range 1 mΩ/cm to 20 mΩ/cm.

6. The method according to any one of claims 1 to 5, characterised in that the transversal thermal conductivity of the fibrous fabric constituting the substrate lies in the range 0.1 W/m. °K to 20 W/m. °K.

## Patentansprüche

1. Verfahren zum chemischen Infiltrieren des Inneren eines elektrisch leitende Fasern enthaltenden fasrigen Substrats mit einem Material aus dessen Dampfphase, umfassend folgende Schritte:
- Einbringen des Substrats in eine Kammer,
- Erhitzen des Substrats durch direkte elektromagnetische Kopplung zwischen einem Induktor und dem Substrat, damit sich im Inneren des Substrats ein Temperaturgradient in der Weise ausbilden kann, daß das Substrat in den von seinen freiliegenden Oberflächen entfernten Bereichen eine höhere Temperatur aufweist als im Bereich der Oberflächen, und
- Einleiten eines Reaktionsgasphasen-Vorläufers des zum Infiltrieren vorgesehenen Materials, wobei dessen Bildung in den eine höhere Temperatur aufweisenden Bereichen des Substrats begünstigt ist,
dadurch gekennzeichnet, daß
- das Substrat durch eine Faserstruktur gebildet wird, in der das Verhältnis ρᵣ/ρ_{c} zwischen dem spezifischen elektrischen Querwiderstand und dem spezifischen elektrischen Längswiderstand mindestens 1,3 beträgt, und das Verhälstnis λᵣ/λ_{c} zwischen der Quer-Wärmeleitfähigkeit und der Längs-Wärmeleitfähigkeit höchstens 0,9 beträgt, und
- das Substrat vollständig in dem von dem Induktor erzeugten Feld gelegen ist, wobei das Substrat und der Induktor ortsfeste Stellungen in bezug auf einander einnehmen.

2. Verfahren nach Anspruch 1, dadurch gekennzeichnet, daß das Substrat durch eine genadelte Faserstruktur gebildet wird, die einen Faser-Volumenanteil von mindestens 20% aufweist.

3. Verfahren nach Anspruch 2, dadurch gekennzeichnet, daß der Faser-Volumenanteil in dem Substrat mindestens 25% beträgt.

4. Verfahren nach einem der Ansprüche 1 bis 3, dadurch gekennzeichnet, daß das Substrat aus einer zweidimensionalen Struktur gebildet ist, die in übereinanderliegenden und genadelten Lagen gewickelt sind.

5. Verfahren nach einem der Ansprüche 1 bis 4, dadurch gekennzeichnet, daß der elektrische Querwiderstand der das Substrat bildenden Faserstruktur zwischen 1 und 20 mΩ/cm liegt.

6. Verfahren nach einem der Ansprüche 1 bis 5, dadurch gekennzeichnet, daß die Quer-Wärmeleitfähigkeit der das Substrat bildenden Faserstruktur zwischen 0,1 und 20 W/m•°K liegt.
